# FASCICULE DE BREVET EUROPEEN

(11) **EP 0 710 065 B1**
(45) Date de publication et mention de la délivrance du brevet: **07.10.1998**
(21) Numéro de dépôt: 95402368.5
(22) Date de dépôt: 24.10.1995
(51) Int. Cl.: H05K 7/14

(54) **Tiroir pour cartes électroniques**
Einschub für elektronische Karten
Drawer for electronic cards

(30) Priorité: 27.10.1994 FR 9412879
(43) Date de publication de la demande: 01.05.1996
(73) Titulaire: GEC ALSTHOM TRANSPORT SA, 75016 Paris (FR)
(72) Inventeur: Ruque, Christian, F-69960 Corbas (FR)
(74) Mandataire: Gosse, Michel

(56) Documents cités:
- EP-A- 0 213 205
- DE-U- 8 910 752
- US-A- 5 040 992
- US-A- 5 259 784

## Description

La présente invention concerne les ensembles de support de cartes électroniques, en général, et porte, plus particulièrement, sur un tiroir pour cartes électroniques et son coffre.

Différents ensembles de support de cartes électroniques de l'art antérieur sont utilisés dans l'industrie.

Une première catégorie de ces support est constituée d'ensembles normalisés. Ils font appel à des tiroirs pour cartes électroniques connus sous le nom de tiroir "Eurofer".

La conception générale de ces tiroirs se base sur l'utilisation de profil et de tôle en aluminium.

Ces tiroirs de l'art antérieur ont des caractéristiques dimensionnelles normalisées.

Des cartes électroniques sont montées perpendiculairement à la face avant de ces tiroirs et sont guidées par des glissières.

Ces cartes électroniques sont susceptibles d'être connectées à des connecteurs électriques solidaires de la face arrière des tiroirs.

A l'arrière de ces connecteurs électriques de carte se situent des connecteurs électriques de sortie fixés sur la face arrière des tiroirs.

Ces connecteurs électriques permettent d'assurer les liaisons électriques entre les cartes et/ou entre les cartes et l'extérieur.

Cette première catégorie d'ensembles de supports de cartes électroniques est à débrochage automatique.

Par débrochage automatique il faut comprendre que pour extraire le tiroir de son coffre il n'est pas nécessaire d'intervenir sur les connecteurs.

Les inconvénients de ces ensembles de support de cartes électroniques de l'art antérieur décrits ci-dessus sont cités ci-après:
- ces ensembles nécessitent deux niveaux de connecteurs flottants,
- le câblage filaire et un nombre de points de connectiques élevé imposent un temps de câblage important
- un coût élevé du fait du nombre élevé de cartes et de connecteurs,
- la fixation des cartes électroniques flottantes ne permet pas une bonne tenue au vibrations,
- la surface de carte individuelle est insuffisante, et
- une profondeur du tiroir importante du fait des différents niveaux de connectique et du sens des cartes.

Une deuxième catégorie d'ensembles de support de cartes électroniques englobe une première solution consistant à disposer une grande carte mère sur laquelle sont disposées les cartes électroniques.

Les connecteurs de cartes sont fixés sur la carte électronique mère.

Des connecteurs de sortie dirigés vers la face avant du coffre sont fixés sur les côtés de la grande carte mère.

Les inconvénients de ces ensembles de support de cartes électroniques de l'art antérieur sont cités ci-après:
- le tiroir n'est plus débrochable mais déconnectable au niveau des connecteurs d'où une augmentation du temps d'intervention pour démonter le tiroir,
- utilisation obligatoire de capots connecteurs pour la raccordement du tiroir, d'où des difficultés de faire le raccordement des câbles blindés dans le connecteurs,
- diminution du nombre de cartes électroniques du fait que les connecteurs de sortie sont disposés sur les côtés de la carte mère en face avant,
- augmentation du volume nécessaire pour l'installation du tiroir dans le coffre pour tenir compte des difficultés d'accès aux connecteurs de sortie et des dégagements des câbles et connecteurs pour extraire le tiroir,
- utilisation de câbles de grandes longueurs pour dégager les câbles et les connecteurs afin d'extraire le tiroir,
- la fixation des cartes électroniques flottantes ne permet pas une bonne tenue au vibrations, et
- la surface de carte individuelle est insuffisante.

Une autre solution des ensembles de support de cartes électroniques de cette catégorie consiste à disposer les connecteurs de sortie sur l'avant des cartes électroniques.

Des connecteurs montés sur une carte mère et disposés à l'arrière des cartes électroniques permettent les liaisons entre cartes.

Les inconvénients de ces ensembles support de cartes électroniques de l'art antérieur sont cités ci-après:
- le tiroir n'est plus débrochable mais déconnectable au niveau des connecteurs d'où une augmentation du temps d'intervention pour démonter le tiroir, d'autant plus que les connecteurs de sortie sont nombreux parce que disposés sur les cartes,
- utilisation obligatoire de capots connecteurs pour la raccordement du tiroir, d'où des difficultés de faire le raccordement des câbles blindés dans le connecteurs,
- une profondeur du tiroir importante du fait du sens des cartes et surtout de l'installation à l'avant des cartes de connecteurs de sortie,
- augmentation du volume nécessaire pour l'installation du tiroir dans le coffre pour tenir compte des dégagements des câbles et des connecteurs pour extraire le tiroir,
- utilisation de câbles de grandes longueurs pour dégager les câbles et les connecteurs afin d'extraire le tiroir,
- la fixation des cartes électroniques flottantes ne permet pas une bonne tenue aux vibrations, et
- la surface de carte individuelle est insuffisante.

Un but de l'invention est la conception d'un tiroir pour cartes électroniques ne présentant pas les inconvénients des ensembles support de l'art antérieur (voir par exemple US-A- 5 259 784).

C'est donc le mérite du déposant que de proposer un tiroir pour cartes électroniques répondant à un concept nouveau se traduisant par un agencement nouveau entre cartes électroniques mères.

L'invention porte sur un tiroir avec cartes électroniques, lesdites cartes électroniques étant connectées sur des cartes mères, lesdites cartes mères étant disposées sur au moins deux plans, chaque plan comportant une ou plusieurs cartes mères parallèles à la face avant dudit tiroir et se caractérise en ce que lesdites cartes mères et leurs cartes électroniques sont superposées les unes aux autres, de manière à former une superposition de compartiments de forme générale pyramidale.

L'invention a également pour objet un tiroir satisfaisant à l'une des caractéristiques suivantes:
- les cartes mères comportent, sur au moins un de leurs côtés, des connecteurs susceptibles d'accueillir des connecteurs de sortie, lesdits connecteurs d'un compartiment étant décalés par rapport aux connecteurs de l'un quelconque des autres compartiments de telle manière que les connecteurs ne soient pas disposés les uns au dessus des autres et soient accessibles à partir de la face avant du tiroir,
- la face avant du coffre est disposée face à la carte mère, ou à l'ensemble des cartes mères d'un même plan, de surface la plus petite,
- au moins une carte mère d'un compartiment n a été supprimée de manière à augmenter le nombre de rangées de connecteurs sur la carte mère du compartiment suivant n+1,
- au moins une carte mère d'un compartiment n a été décalée, de manière à être alignée sur un des côtés du compartiment précédent n-1 ou du compartiment suivant n+1, afin que les connecteurs de ladite carte mère dudit compartiment n soient plus particulièrement disposés sur l'un des côté du tiroir,
- l'ensemble des compartiments sont aligné sur un des côtés du tiroir, afin de disposer l'ensemble des connecteurs sur un seul côté du tiroir,
- au moins un compartiment comporte une carte mère unique,
- au moins un compartiment comporte deux demi-cartes mères,
- au moins un compartiment comporte quatre quarts de cartes mères,
- au moins un compartiment comporte une demi-carte mère et deux quarts de cartes mères,
- les cartes mères sont disposées sur des plans parallèles à la face avant du tiroir au moyens d'entretoises,
- au moins deux cartes mères sont connectées électriquement entre elles au moyen d'au moins l'une desdites cartes électroniques.

Le tiroir pour cartes électroniques a comme avantages:
- de répondre à un concept modulaire adaptable facilement au besoin fonctionnel à réaliser, soit par l'adaptation du nombre de compartiments ou de la hauteur de chaque compartiment, soit par l'association multiple au niveau des compartiments, soit par le choix des cartes mères à chaque compartiment, soit par le choix des points de sortie des câbles,
- la réduction des coûts en utilisant des cartes mères de grandes surfaces et/ou en diminuant le nombre de cartes mères, en choisissant le format de la carte le mieux adapté au besoin fonctionnel et en diminuant le câblage filaire du fait de l'emploi de cartes mères intégrant les connecteurs de sortie et une grande partie du câblage,
- l'amélioration de la fiabilité par la diminution du câblage filaire et du nombre de point de connexion,
- la réduction du nombre de connecteurs de sortie et entre cartes du fait de l'adaptation du choix de la surface des cartes mères par compartiment,
- la diminution du volume du tiroir du fait de l'emploi de grandes cartes, du choix de la surface des cartes mères, de l'intégration des connecteurs de sortie dans le volume défini par la façade avant du tiroir, et du nombre de compartiments,
- la réduction du nombre de zones de dégagement des connecteurs de sortie dans le coffre, et
- de permettre un raccordement des connecteurs de façon relativement aisé du fait que le tiroir est peu profond et que les connecteurs de sortie sont décalés en fonction du compartiment.

D'autres buts, caractéristiques et avantages de l'invention apparaîtront à la lecture de la description des modes de réalisation préférés du tiroir pour cartes électroniques, description faite en liaison avec les dessins joints dans lesquels:
- la figure 1 est une vue de dessus en coupe partielle d'un premier mode de réalisation préféré du tiroir pour cartes électroniques comportant trois compartiments, conforme à l'invention,
- la figure 2 est une vue de face du tiroir pour cartes électroniques représenté à la figure 1,
- la figure 3 est une vue de dessus en coupe partielle du tiroir pour cartes électroniques selon le premier mode de réalisation préféré illustrant un agencement particulier permettant de disposer de quatre rangées de connecteurs sur la carte mère du deuxième compartiment,
- la figure 4 est une vue de dessus en coupe partielle du tiroir pour cartes électroniques selon le premier mode de réalisation préféré illustrant un agencement particulier permettant de disposer les connecteurs plus particulièrement sur l'un des côtés du tiroir,
- les figures 5 et 6 sont des vues de dessus en coupe partielle du tiroir pour cartes électroniques selon le premier mode de réalisation préféré illustrant deux autres agencements particuliers, et
- les figures 7A à 7F sont des représentations schématiques de combinaisons possibles entre cartes mères pour chaque compartiment.

De manière générale, dans un tiroir 1 pour cartes électroniques 2A-2C, les cartes électroniques sont connectées sur des cartes mères 3A-3C.

Dans le tiroir pour cartes électroniques de l'invention, les cartes mères sont disposées sur au moins deux plans.

Chacun de ces plans comporte une ou plusieurs cartes mères 3A-3C parallèles à la face avant 6 du tiroir, les cartes mères et leurs cartes électroniques sont superposées les unes aux autres, de manière à former une superposition de compartiments A-C de forme générale pyramidale.

Les cartes mères 3A-3C comportent, de préférence, sur au moins un de leurs côtés, des connecteurs 4A-4C susceptibles d'accueillir des connecteurs de sortie 5A-5C.

Les connecteurs d'un compartiment sont décalés par rapport aux connecteurs de l'un quelconque des autres compartiments de telle manière que les connecteurs ne soient pas disposés les uns au dessus des autres et soient accessibles à partir de la face avant du tiroir.

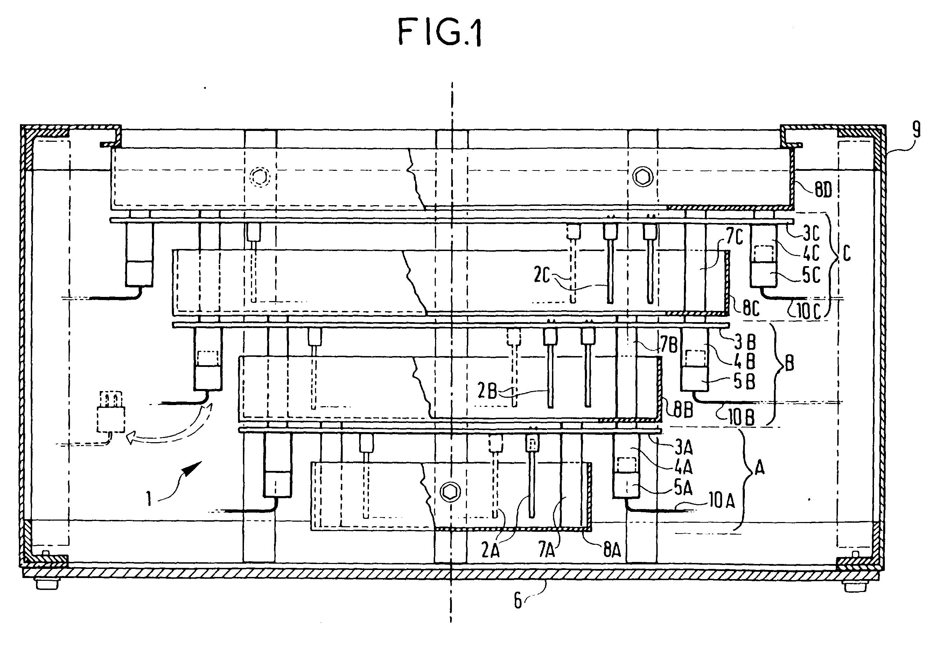

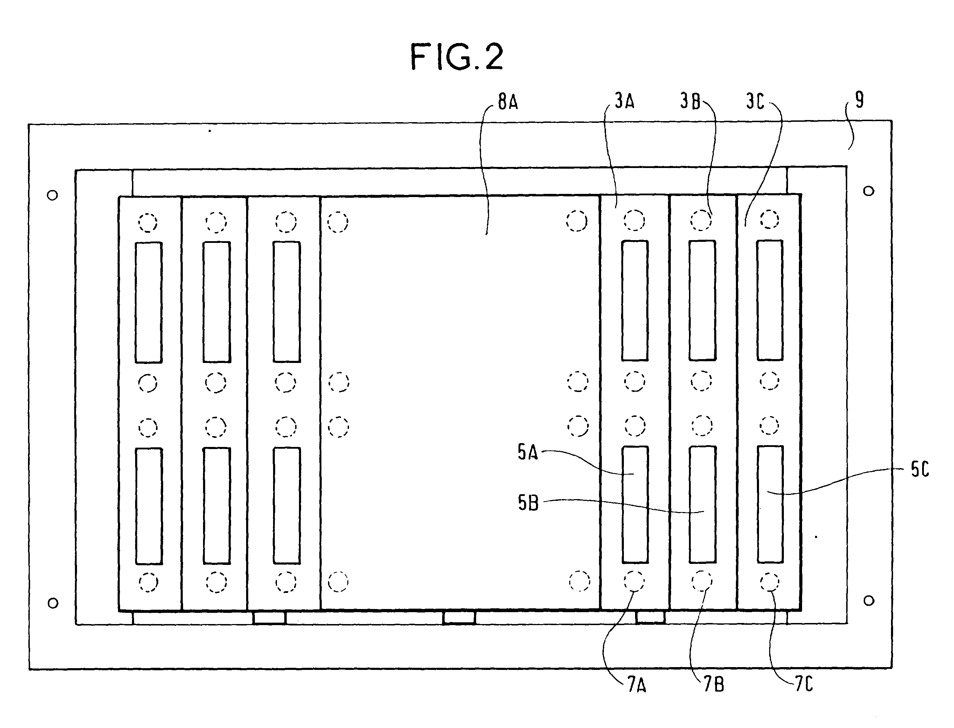

Les figures 1 et 2 représentent deux vues de dessus en coupe partielle d'un premier mode de réalisation préféré du tiroir pour cartes électroniques comportant trois compartiments conforme à l'invention.

Conformément au premier mode de réalisation préféré de l'invention, le tiroir 1 pour cartes électroniques comporte des cartes électroniques 2A-2C, encore appelées cartes électroniques filles, connectées sur des cartes mères 3A-3C.

Les cartes mères sont disposées sur au moins deux plans parallèlement à une face avant 6 d'un coffre 9, chaque plan comportant une ou plusieurs cartes mères.

Les plans sont superposés les uns aux autres, de manière à former un empilage de forme pyramidale, le sommet de l'empilage étant constitué par la carte mère ou l'ensemble de cartes mères de surface la plus petite.

Le tiroir 1 pour cartes électroniques 2A-2C comporte donc de grandes cartes mères 3A-3C sur les petits côtés desquels sont fixés des connecteurs femelles 4A-4C.

Des connecteurs mâles de sortie 5A-5C sont susceptibles d'être connectés manuellement aux connecteurs femelles 4A-4C. Ces connecteurs mâles de sortie 5A-5C sont solidaires de cablâge de sortie 10A-10C.

Chaque modèle de cartes mères possède un ou plusieurs connecteurs femelles.

L'ensemble des cartes mères est disposé parallèlement au plan de la face avant 6 du coffre 9 de manière à former un empilage de plusieurs compartiments A-C de cartes mères.

Ces cartes mères ont des largeurs différentes fonction du compartiment dont elles dépendent, de telle sorte que les câblages de sortie 10A-10C puissent passer de chaque côté de la carte mère ou des cartes mères et puissent donc être accessibles de la face avant 6 du coffre 9.

L'ensemble des cartes mères est disposé et maintenu de manière à former un empilage de forme pyramidale.

Par empilage de forme pyramidale il faut comprendre un empilage de cartes mères tel que l'enveloppe fictive extérieure définie par l'ensemble des cartes mères se compose d'une succession de marches selon l'axe longitudinal et/ou selon l'axe radial pour former un podium selon l'un et/ou l'autre de ces axes.

Comme indiqué précédemment, la face avant 6 du coffre 9 est disposée face à la carte mère, ou à l'ensemble des cartes mères d'un même plan, de surface la plus petite.

La réalisation du tiroir pour cartes électroniques de l'invention nécessite de fixer les différentes cartes mères entre elles par l'intermédiaire d'entretoises 7A-7C.

Ces entretoises 7A-7C sont de préférence solidaires de plaques de rigidification 8B-8D des cartes mères 3A-3C et/ou de plaques de protection 8A-8C des cartes électroniques filles 2A-2C.

En complément de ce qui précède, le tiroir tel que défini peut comporter au moins deux cartes mères 3A-3C connectées électriquement entre elles au moyen d'au moins l'une des cartes électroniques 2A-2C.

Pour ce faire, la carte électronique concernée comporte de préférence des moyens de connexion automatique avec au moins l'une des cartes mères.

La figure 2 représente une vue de face en coupe partielle d'un premier mode de réalisation préféré du tiroir pour cartes électroniques conforme à l'invention dans laquelle la face avant 6 du coffre 9 n'est pas représentée.

On retrouve dans cette figure 2 la plaque de protection 8A des cartes électroniques filles de la carte mère 3A du premier compartiment A, les cartes mères 3A-3C des premier A, deuxième B et troisième C compartiments, les connecteurs mâles de sortie 5A-5C et enfin les entretoises de fixation 7A-7C des cartes mères 3A-3C.

L'ensemble du tiroir est susceptible d'être positionné dans le coffre 9 sur lequel vient se fixer la face avant.

L'encombrement global, la masse et le coût du tiroir pour cartes électroniques peuvent être adapter préalablement en fonction des besoins.

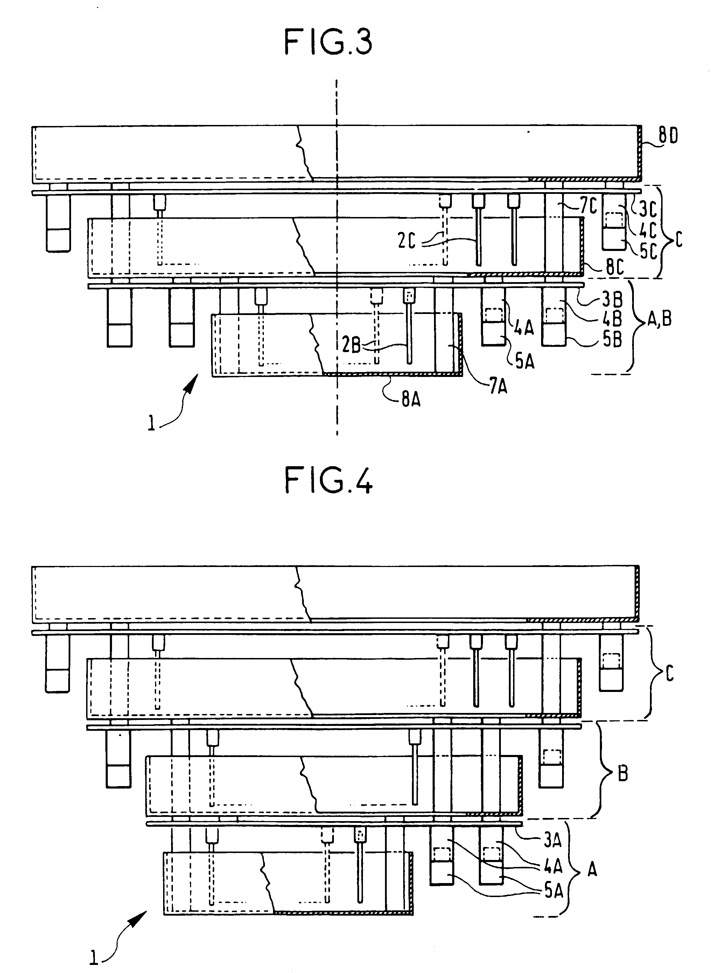

La figure 3 est une vue de dessus en coupe partielle du tiroir 1 pour carte électroniques 2 illustrant un agencement particulier entre la carte mère 3B du deuxième compartiment et le premier compartiment A.

La suppression de la carte mère du premier compartiment A et de la plaque de rigidification et de protection du deuxième compartiment B, permet de disposer de quatre rangées de connecteurs 4A, 5A et 4B, 5B sur la carte mère 3B du deuxième compartiment B et, comme obtenues dans le mode de réalisation précédent, de deux rangées de connecteurs 4C, 5C sur la carte mère 3C du troisième compartiment C.

Dans ce mode de réalisation particulier, les entretoises de fixation 7B du deuxième compartiment B ont été supprimées, seules les entretoises 7A et 7C des premier et troisième compartiments subsistent.

De plus, subistent également les plaques 8C et 8D de rigidification des cartes mères 3B, 3C ainsi que les plaques de protection 8A, 8C des cartes électroniques 2B et 2C.

La figure 4 est une vue de dessus en coupe partielle du tiroir 1 pour carte électroniques illustrant un agencement entre le premier compartiment A et le deuxième compartiment B permettant de disposer tous les connecteurs 4A, 5A de la carte mère 3A du premier compartiment A sur l'un des côtés du tiroir 1 ou, plus précisément, sur l'un des côtés de la carte mère 3A du premier compartiment A.

Conformément à cet autre mode de réalisation représenté à la figure 4, il est possible de décaler l'un des compartiments n, par exemple le premier compartiment A, de manière à l'aligner sur un des côtés du compartiment précédent n-1 ou du compartiment suivant n+1, dans le cas représenté à la figure 4: le deuxième compartiment B.

Un tel agencement permet de disposer les connecteurs plus particulièrement sur une extrémité de l'une des cartes mères.

Il est également possible d'aligner plusieurs compartiments, par exemple les compartiments A et B, par rapport à un des autres compartiments, par exemple le compartiment C, de manière à répartir les compartiments selon un autre agencement.

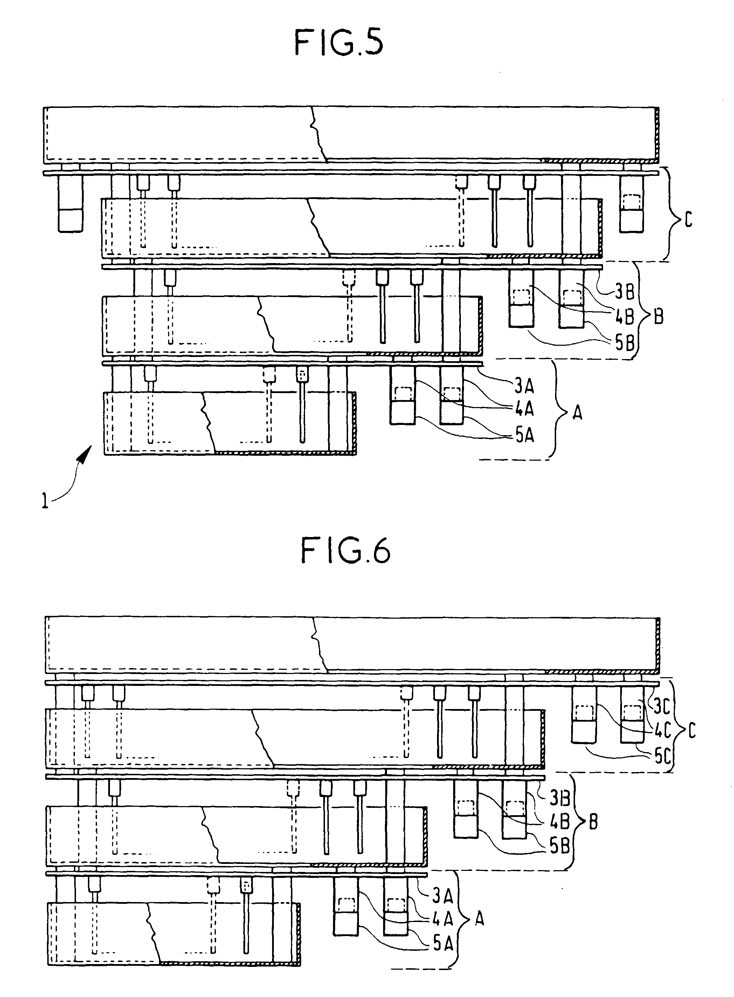

Un tel mode de réalisation est représenté à la figure 5.

Il est également possible d'aligner l'ensemble des compartiments A-C sur un des côtés du tiroir, un tel alignement est par exemple représenté à la figure 6.

Un tel agencement permet de disposer l'ensemble des connecteurs sur un seul côté du tiroir.

Il est possible de choisir et d'associer, pour chaque compartiment, les cartes mères souhaitées selon un grand nombre de combinaisons.

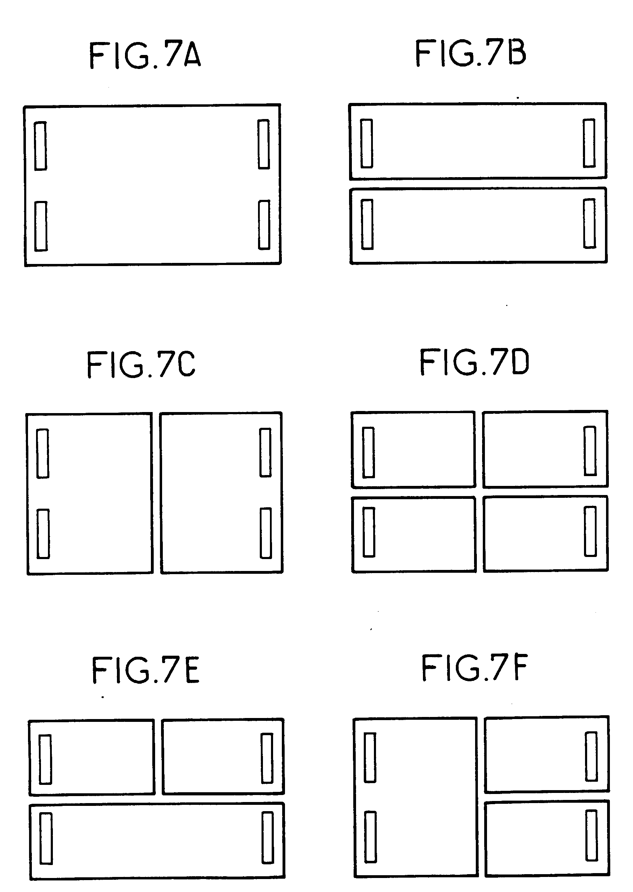

Pour un tiroir comportant six compartiments successifs, l'agencement des cartes mères selon une forme générale pyramidale est obtenu en sélectionnant les différentes cartes mères dans la liste ci-dessous:
- une carte mère unique (figure 7A),
- deux demi-cartes mères disposées horizontalement (figure 7B),
- deux demi-cartes mères disposées verticalement (figure 7C),
- quatre quarts de cartes mères (figure 7D),
- une demi-carte mère disposée horizontalement associée à deux quarts de cartes mères également disposées horizontalement (figure 7E), et
- une demi-carte mère disposée verticalement associée à deux quarts de cartes mères disposées verticalement (figure 7F).

Il est clair que les cartes mères ont été représentées aux figures 7A à 7F avec toutes la même taille mais que les tailles de ces cartes mères diffèrent selon leur appartenance à l'un ou l'autre des compartiments.

Concernant la réalisation technique du tiroir pour cartes électroniques, à titre d'exemple, les connecteurs de sortie sont soudés à la vague sur les cartes mères.

Ceci a comme avantage que le câblage de sortie se trouve être intégré dans le volume défini par la face avant du tiroir.

La fixation du tiroir à son coffre s'effectue au moyens de plusieurs vis.

Enfin, les plaques 8A-8D peuvent être adaptées et associées à chaque compartiment pour reprendre les cartes du compartiment concerné et ainsi assurer des performances plus élevées en termes de vibration et de choc mais également servir d'écran thermique entre les compartiments.

Un tiroir comportant de tel cadres permet la reprise de la fixation sur son coffre par l'intermédiaire de vis de préférence disposées au niveau du troisième compartiment sur la plaque 8D.

## Revendications

1. Tiroir (1) avec cartes électroniques (2A-2C), lesdites cartes électroniques (2A-2C) étant connectées sur des cartes mères (3A-3C), lesdites cartes mères (3A-3C) étant disposées sur au moins deux plans, chaque plan comportant une ou plusieurs cartes mères (3A-3C) parallèles à la face avant (6) dudit tiroir (1), caractérisé en ce que lesdites cartes mères et leurs cartes électroniques sont superposées les unes aux autres, de manière à former une superposition de compartiments (A-C) de forme générale pyramidale.

2. Tiroir selon la revendication 1, dans lequel lesdites cartes mères (3A-3C) comportent, sur au moins un de leurs côtés, des connecteurs (4A-4C) susceptibles d'accueillir des connecteurs de sortie (5A-5C), lesdits connecteurs d'un compartiment étant décalés par rapport aux connecteurs de l'un quelconque des autres compartiments de telle manière que les connecteurs ne soient pas disposés les uns au dessus des autres et soient accessibles à partir de la face avant du tiroir.

3. Tiroir selon l'une quelconque des revendications 1 et 2, dans lequel la face avant (6) du tiroir (1) est disposée face à la carte mère, ou à l'ensemble des cartes mères d'un même plan, de surface la plus petite.

4. Tiroir selon l'une quelconque des revendications 1 à 3, dans lequel au moins une carte mère d'un compartiment n a été supprimée de manière à augmenter le nombre de connecteurs sur la carte mère du compartiment suivant n+1.

5. Tiroir selon l'une quelconque des revendications 1 à 3, dans lequel au moins une carte mère d'un compartiment n a été décalée, de manière à être alignée sur un des côtés du compartiment précédent n-1 ou du compartiment suivant n+1, afin que les connecteurs de ladite carte mère dudit compartiment n soient plus particulièrement disposés sur l'un des côtés du tiroir.

6. Tiroir selon l'une quelconque des revendications 1 à 3, dans lequel l'ensemble des compartiments (A-C) sont aligné sur un des côtés du tiroir, afin de disposer l'ensemble des connecteurs sur un seul côté du tiroir.

7. Tiroir selon l'une quelconque des revendications 1 à 6, dans lequel au moins un compartiment comporte une carte mère unique.

8. Tiroir selon l'une quelconque des revendications 1 à 6, dans lequel au moins un compartiment comporte deux demi-cartes mères.

9. Tiroir selon l'une quelconque des revendications 1 à 6, dans lequel au moins un compartiment comporte quatre quarts de cartes mères.

10. Tiroir selon l'une quelconque des revendications 1 à 6, dans lequel au moins un compartiment comporte une demi-carte mère et deux quarts de cartes mères.

11. Tiroir selon l'une quelconque des revendications 1 à 10, dans lequel les cartes mères (3A-3C) sont disposées sur des plans parallèles à la face avant (6) du tiroir (1) au moyens d'entretoises (7A-7C).

12. Tiroir selon l'une quelconque des revendications 1 à 11, dans lequel au moins deux cartes mères (3A-3C) sont connectées électriquement entre elles au moyen d'au moins l'une desdites cartes électroniques (2A-2C).

## Patentansprüche

1. Einschub (1) mit elektronischen Platinen(2A-2C), wobei die elektronischen Platinen (2A-2C) an Hauptplatinen (3A-3C) angeschlossen sind, wobei die Hauptplatinen (3A-3C) in wenigstens zwei Ebenen angeordnet sind, wobei jede Ebene eine oder mehrere zur Vorderseite (6) des Einschubs (1) parallele Hauptplatinen (3A-3C) umfaßt, **dadurch gekennzeichnet**, daß die Hauptplatinen und ihre elektronischen Platinen einander so überlagert sind, daß sie eine allgemein pyramidenförmige Überlagerung von Kammern (A-C) bilden.

2. Einschub (1) nach Anspruch 1, bei dem die Hauptplatinen (3A-3C) an wenigstens einer ihrer Seiten Verbinder (4A-4C) umfassen, die in der Lage sind, Ausgangsverbinder (5A-5C) aufzunehmen, wobei die Verbinder einer Kammer gegen die Verbinder einer beliebigen der anderen Kammern so versetzt sind, daß die Verbinder nicht übereinander angeordnet sind und daß sie von der Vorderseite des Einschubs her zugänglich sind.

3. Einschub nach einem beliebigen der Ansprüche 1 und 2, bei dem die Vorderseite (6) des Einschubs (1) derjenigen Hauptplatine oder Gesamtheit von Hauptplatinen zugewandt angeordnet ist, die die kleinste Oberfläche hat.

4. Einschub nach einem beliebigen der Ansprüche 1 bis 3, bei dem wenigstens eine Hauptplatine einer Kammer n fortgelassen ist, um die Zahl von Verbindern an der Hauptplatine der folgenden Kammer n+1 zu erhöhen.

5. Einschub nach einem beliebigen der Ansprüche 1 bis 3, bei dem wenigstens eine Hauptplatine einer Kammer n so versetzt ist, daß sie mit einer der Seiten der vorhergehenden Kammer n-1 oder der nachfolgenden Kammer n+1 fluchtet, so daß die Verbinder der Hauptplatine der Kammer n insbesondere an der einen Seite des Einschubs angeordnet sind.

6. Einschub nach einem beliebigen der Ansprüche 1 bis 3, bei dem die Gesamtheit der Kammern A-C an einer Seite des Einschubs (1) fluchten, um sämtliche Verbinder an einer einzigen Seite des Einschubs anzuordnen.

7. Einschub nach einem beliebigen der Ansprüche 1 bis 6, bei dem wenigstens eine Kammer eine einzige Hauptplatine umfaßt.

8. Einschub nach einem beliebigen der Ansprüche 1 bis 6, bei dem wenigstens eine Kammer zwei Halb-Hauptplatinen umfaßt.

9. Einschub nach einem beliebigen der Ansprüche 1 bis 6, bei dem wenigstens eine Kammer vier Viertel-Hauptplatinen umfaßt.

10. Einschub nach einem beliebigen der Ansprüche 1 bis 6, bei dem wenigstens eine Kammer eine Halb-Hauptplatine und zwei Viertel-Hauptplatinen umfaßt.

11. Einschub nach einem beliebigen der Ansprüche 1 bis 10, bei dem die Hauptplatinen (3A-3C) in zur Vorderseite (6) des Einschubs (1) parallelen Ebenen mit Hilfe von Streben (7A-7C) angeordnet sind.

12. Einschub nach einem beliebigen der Ansprüche 1 bis 11, bei dem wenigstens zwei Hauptplatinen (3A-3C) miteinander mit Hilfe wenigstens einer der elektronischen Platinen (2A-2C) verbunden sind.

## Claims

1. Subrack (1) with electronic circuit boards (2A-2C), said electronic circuit boards (2A-2C) being connected to mother boards (3A-3C), said mother boards (3A-3C) being disposed in at least two planes, each plane containing one or more mother boards (3A-3C) parallel to the front face (6) of said subrack (1), characterised in that said mother boards and their electronic circuit boards are superposed to form a stack of compartments (A-C) in the general shape of a pyramid.

2. Subrack according to claim 1 wherein said mother boards (3A-3C) have connectors (4A-4C) on at least one side adapted to receive output connectors (5A-5C), said connectors of one compartment being shifted relative to the connectors of any other compartment so that the connectors are not disposed one above the other and are accessible from the front face of the subrack.

3. Subrack according to claim 1 or claim 2 wherein the front face (6) of the subrack (1) faces the mother board or the set of coplanar mother boards having the smallest area.

4. Subrack according to any one of claims 1 to 3 wherein at least one mother board from a compartment n is dispensed with in order to increase the number of connectors on the mother board of the next compartment n+1.

5. Subrack according to any one of claims 1 to 3 wherein at least one mother board of a compartment n is offset so that it aligns with one side of the previous compartment n-1 or the next compartment n+1 so that the connectors of said mother board of said compartment n can be disposed on one side of the subrack.

6. Subrack according to any one of claims 1 to 3 wherein all of the compartments (A-C) are aligned with one side of the subrack so that all of the connectors can be disposed on one side of the subrack.

7. Subrack according to any one of claims 1 to 6 wherein at least one compartment contains a single mother board.

8. Subrack according to any one of claims 1 to 6 wherein at least one compartment contains two mother half-boards.

9. Subrack according to any one of claims 1 to 6 wherein at least one compartment contains four mother quarter-boards.

10. Subrack according to any one of claims 1 to 6 wherein at least one compartment contains one mother half-board and two mother quarter-boards.

11. Subrack according to any one of claims 1 to 10 wherein the mother boards (3A-3C) are disposed in planes parallel to the front face (6) of the subrack (1) by means of spacers (7A-7C).

12. Subrack according to any one of claims 1 to 11 wherein at least two mother boards (3A-3C) are electrically interconnected by at least one of said electronic circuit boards (2A-2C).
